# EUROPÄISCHE PATENTANMELDUNG

(11) **EP 4 312 374 A1**
(43) Veröffentlichungstag der Anmeldung: **31.01.2024**
(21) Anmeldenummer: 22186689.0
(22) Anmeldetag: 25.07.2022
(51) Int. Cl.: H03K 17/975

(54) **VORRICHTUNG UND VERFAHREN ZUR ERKENNUNG EINER BERÜHRUNG SOWIE ROBOTER**

(71) Anmelder: SICK AG, 79183 Waldkirch (DE)
(72) Erfinder: WEBER, Thomas, 77960 Seelbach (DE)
(74) Vertreter: Manitz Finsterwald Patent- und Rechtsanwaltspartnerschaft mbB

(57) **Zusammenfassung**

Vorrichtung zur Erkennung einer Berührung, umfassend ein Berührungselement umfassend einen Kern aus einem dielektrischen Material, eine in dem Kern angeordnete Hochfrequenzleitung und eine um den Kern angeordnete Ummantelung, die ein Bezugspotential für die Hochfrequenzleitung ausbildet, einen mit der Hochfrequenzleitung verbundenen Signalerzeuger, der ausgebildet ist, ein Hochfrequenzsignal zu erzeugen und die Hochfrequenzleitung damit zu beaufschlagen und eine Reflexion des Hochfrequenzsignals an der Hochfrequenzleitung zu erfassen, und eine mit dem Signalerzeuger verbundene Auswertungseinheit, die ausgebildet ist, eine durch eine Positionsänderung der Ummantelung relativ zu der Hochfrequenzleitung geänderte Reflexion des Hochfrequenzsignals auszuwerten und die Positionsänderung zu ermitteln.

## Beschreibung

Die Erfindung betrifft eine Vorrichtung zur Erkennung einer Berührung, einen Roboter sowie ein Verfahren zur Erkennung einer Berührung.

Vorrichtungen und Verfahren zur Erkennung einer Berührung sind prinzipiell bekannt. Beispielsweise sind Vorrichtungen und Verfahren mit kapazitiver und/oder resistiver Kraftmessung zur Berührungserkennung bekannt. Diese bekannten Verfahren und Vorrichtung sind jedoch störanfällig und wenig genau.

Es ist daher eine Aufgabe der vorliegenden Erfindung, eine verbesserte Vorrichtung zur Erkennung einer Berührung, einen verbesserten Roboter sowie ein verbessertes Verfahren zur Erkennung einer Berührung bereitzustellen.

Diese Aufgabe wird zunächst gelöst durch eine Vorrichtung zur Erkennung einer Berührung. Die Vorrichtung umfasst dabei ein Berührungselement umfassend einen Kern aus einem dielektrischen Material, eine in dem Kern angeordnete Hochfrequenzleitung und eine um den Kern angeordnete Ummantelung, die ein Bezugspotential für die Hochfrequenzleitung ausbildet, einen mit der Hochfrequenzleitung verbundenen Signalerzeuger, der ausgebildet ist, ein Hochfrequenzsignal zu erzeugen und die Hochfrequenzleitung damit zu beaufschlagen und eine Reflexion des Hochfrequenzsignals an der Hochfrequenzleitung zu erfassen, und eine mit dem Signalerzeuger verbundene Auswertungseinheit, die ausgebildet ist, eine durch eine Positionsänderung der Ummantelung relativ zu der Hochfrequenzleitung geänderte Reflexion des Hochfrequenzsignals auszuwerten und die Positionsänderung zu ermitteln.

Die Vorrichtung dient der Erkennung einer Berührung, insbesondere für Roboter, Greifer oder Cobot-Anwendungen. Die Vorrichtung kann auch eingesetzt werden für sogenannte Metaverse-Anwendungen, in denen auch eine Erkennung einer Berührung und/oder Bewegungen von Gliedmaßen wünschenswert sein können. Die Vorrichtung kann auch eingesetzt werden zur Erkennung von Zusammenstößen oder Berührungen eines Roboters mit Werkstücken oder Vorrichtungen. Die Vorrichtung kann auch als taktiler Sensor bezeichnet werden.

Die Vorrichtung umfasst zunächst ein Berührungselement. Das Berührungselement umfasst dabei einen Kern. Dabei ist der Kern aus einem dielektrischen Material ausgebildet. Dielektrisch meint vorliegend schwach- oder nichtleitend und dient als Isolator. Der Kern ist dabei insbesondere aus einem verformbaren Material ausgebildet, sodass er eine Berührung aufnehmen bzw. sich bei einer Berührung verformen kann. Das Material des Kerns kann beispielsweise aus einem Schaumstoff hergestellt sein, der kompressibel ist. Alternativ kann der Kern aus einer Luftpolsterfolie bestehen. Das Material des Kerns kann insbesondere auf die Art der Anwendung der Vorrichtung zugeschnitten sein. Insbesondere kann für einen Einsatz in einem Umfeld mit üblicherweise schnellen und/oder kraftvollen Bewegungen ein anderes Material verwendet werden als in einem Umfeld mit üblicherweise langsamen und/oder schwachen Bewegungen.

Das Berührungselement der Vorrichtung umfasst weiter eine Hochfrequenzleitung, die in dem Kern angeordnet ist. Dabei ist die Hochfrequenzleitung ausgebildet ein Hochfrequenzsignal zu empfangen und zu führen, sodass es sich darin ausbreiten kann. Hochfrequenz meint in diesem Kontext ein elektromagnetisches Signal, das eine Frequenz größer 1 kHz, insbesondere größer 10 kHz, weiter insbesondere größer 100 kHz, weiter insbesondere größer 1 MHz, weiter insbesondere größer 1 GHz aufweist. Die Hochfrequenzleitung ist dabei in dem Kern angeordnet und erstreckt sich darin. Die Hochfrequenzleitung kann dabei beispielsweise als Draht oder als Leiterbahn, insbesondere als Flachleiterbahn ausgebildet sein. Insbesondere ist die Hochfrequenzleitung als Koaxialleitung ausgebildet.

Das Berührungselement der Vorrichtung umfasst weiter eine Ummantelung. Die Ummantelung ist dabei um den Kern angeordnet und bildet ein Bezugspotential für die Hochfrequenzleitung aus. Die Ummantelung ist dabei insbesondere mit der Hochfrequenzleitung verbunden, insbesondere elektrisch leitend verbunden. Weiter insbesondere ist die Ummantelung kapazitiv mit der Hochfrequenzleitung gekoppelt. Ein Bezugspotential kann auch als Masse oder Ground bezeichnet werden oder als potentialfrei. Insbesondere kann das Bezugspotential den elektrischen Minuspol zur Hochfrequenzleitung darstellen. Die Ummantelung kann insbesondere abschnittsweise und/oder teilweise um den Kern angeordnet sein. Insbesondere kann die Ummantelung ausschließlich an einer gewünschten Berührungsposition um den Kern angeordnet sein.

Das Berührungselement kann insbesondere mattenförmig ausgebildet sein. Mattenförmig meint vorliegend eine im wesentlichen quaderförmige Form mit einer Ausdehnung in einer Länge, die größer ist als eine Ausdehnung in einer Breite und eine Ausdehnung in einer Höhe, die kleiner ist als die Ausdehnung in der Breite. So kann das Berührungselement besonders gut um Gegenstände, deren Berührungen erfasst werden sollen, angeordnet werden.

Die Vorrichtung umfasst auch einen mit der Hochfrequenzleitung des Berührungselements verbundenen Signalerzeuger. Der Signalerzeuger ist dabei ausgebildet, ein Hochfrequenzsignal zu erzeugen und die Hochfrequenzleitung damit zu beaufschlagen. Der Signalerzeuger ist weiter ausgebildet, eine Reflexion des Hochfrequenzsignals an der Hochfrequenzleitung zu erfassen. Der Signalerzeuger kann auch als Signalgenerator bezeichnet werden und ist dabei beispielsweise über einen Koaxialanschluss mit der Hochfrequenzleitung verbunden. Durch die Beaufschlagung der Hochfrequenzleitung breitet sich ein elektromagnetisches Signal entlang der Hochfrequenzleitung aus und wird, in Abhängigkeit des Leitungsabschlusses, charakteristisch reflektiert. Diese Reflexion kann der Signalerzeuger empfangen.

Die Vorrichtung umfasst auch eine Auswertungseinheit, die mit dem Signalerzeuger verbunden ist. Der Signalerzeuger stellt der Auswertungseinheit die gemessene Reflexion und insbesondere auch das beaufschlagte Signal bereit. Dabei ist die Auswertungseinheit ausgebildet, eine durch eine Positionsänderung der Ummantelung relativ zu der Hochfrequenzleitung geänderte Reflexion des Hochfrequenzsignals auszuwerten und dadurch eine Positionsänderung zu ermitteln.

Durch eine Berührung der Ummantelung bzw. des Berührungselements wird eine Positionsänderung der Ummantelung relativ zur Hochfrequenzleitung erzeugt. Hierdurch wird die charakteristische Reflexion der Hochfrequenzleitung verändert. Insbesondere wird durch die Positionsänderung eine Reflexionsstelle geschaffen bzw. erzeugt, die beabstandet zu dem Leitungsabschluss ist und somit im Gegensatz zu einem unberührten Berührungselement eine unterschiedliche Reflexion erzeugt.

Die Auswertungseinheit ist dabei ausgebildet, diese unterschiedliche Reflexion zu erfassen und auszuwerten. Insbesondere ist die Auswertungseinheit zunächst ausgebildet, zu erfassen ob überhaupt eine Berührung des Berührungselements bzw. der Ummantelung stattfindet. Dazu ist die Auswertungseinheit insbesondere Prozessorgestützt und/oder wendet digitale Auswertungsmethoden an. Insbesondere nutzt die Auswertungseinheit einen oder mehrere dafür programmierte FPGA.

Insbesondere ist die Auswertungseinheit ausgebildet, Kontextinformationen der Vorrichtung zu empfangen und zu berücksichtigen. Kontextinformationen sind solche Informationen, die die Anordnung, die Form, die Materialien, die Komponenten und/oder die Größe des Berührungselements berücksichtigen.

Durch die erfindungsgemäße Vorrichtung wird eine Berührung besonders zuverlässig erkannt. Insbesondere skaliert die Vorrichtung bzw. das Berührungselement besonders einfach. Die Vorrichtung eignet sich insbesondere für große Flächen entlang deren eine Berührung erkannt werden soll. Darüber hinaus ist die Vorrichtung bzw. das Berührungselement besonders robust, da nur eine einzige Leitung verwendet wird. Somit sind Anwendungen der Vorrichtung bzw. des Berührungselements an beweglichen Elementen besonders gut möglich. Ebenso ist die Vorrichtung besonders unanfällig für magnetische Felder und kann somit gut in einem Umfeld mit elektrischen Antrieben eingesetzt werden. Auch ist die Vorrichtung besonders verschleißarm und robust gegenüber einer dauerhaften Anwendung.

Gemäß einer Ausführungsform ist die Hochfrequenzleitung schlangenförmig innerhalb des Kerns angeordnet.

Schlangenförmig meint vorliegend, dass die Hochfrequenzleitung sich sowohl entlang einer Länge des Berührungselements bzw. des Kerns, als auch entlang einer Breite des Berührungselements bzw. des Kerns, insbesondere abwechselnd entlang der Länge und entlang der Breite, ausbreitet. Weiter insbesondere breitet sich die Hochfrequenzleitung länger entlang der Breite als entlang der Länge aus. Hierdurch wird eine besonders große Abdeckung des Kerns bzw. des Berührungselements durch die Hochfrequenzleitung ermöglicht. Insbesondere sind die Abschnitte der Hochfrequenzleitung, die sich entlang der Breite erstrecken, weniger als 50 mm, insbesondere weniger als 10 mm, weiter insbesondere weniger als 5 mm entlang der Länge voneinander beabstandet. Hierdurch lässt sich besonders gut eine Berührung durch eine Extremität, wie beispielsweise ein Finger ermitteln.

Weiter insbesondere kann die Hochfrequenzleitung zumindest abschnittsweise oder vollständig mäanderförmig in dem Kern angeordnet sein. Mäanderförmig bedeutet vorliegend ein Muster, in dem sich die Hochfrequenzleitung entlang der Länge und der Breite erstreckt.

Alternativ oder zusätzlich kann die Hochfrequenzleitung auch zumindest abschnittsweise oder vollständig in der Form einer Hilbert-Kurve erstrecken. Insbesondere handelt es sich dabei um eine Hilbert-Kurve der 2. Iteration, die dem Mäandermuster ähnlich ist. Auch durch diese Muster lassen sich besonders gut Berührungen kleinerer Gliedmaßen erfassen.

Durch diese Ausführungsformen wird eine besonders genaue und präzise Erfassung einer Berührung ermöglicht.

Gemäß einer alternativen Ausführungsform ist ein erstes Ende der Hochfrequenzleitung mit dem Signalerzeuger verbunden und ein zweites Ende der Hochfrequenzleitung ist innerhalb des Kerns angeordnet.

Das erste Ende kann dabei insbesondere, wie oben beschrieben, einen Koaxialanschluss aufweisen und außerhalb des Kerns angeordnet sein, um mit dem Signalerzeuger verbunden zu werden. Das andere, zweite Ende ist dabei innerhalb des Kerns angeordnet und bildet dort den Leitungsabschluss. Insbesondere kann ein passender Leitungsabschluss so gewählt werden, dass Reflexionen verhindert werden.

Alternativ kann das zweite Ende auch als offenes Leitungsende ausgebildet sein. Hierdurch entstehen zwar Reflexionen, die jedoch zur Erkennung der Positionsänderung genutzt werden können. Insbesondere wenn das zweite Ende als offenes Leitungsende ausgebildet ist, und die Erfassung darauf ausgelegt ist, kann das Berührungselement durch einen Benutzer auf eine beliebige Länge zugeschnitten werden.

Gemäß einer Ausführungsform ist ein erstes Ende der Hochfrequenzleitung mit dem Signalerzeuger verbunden und ein zweites Ende der Hochfrequenzleitung ist außerhalb des Kerns angeordnet, wobei das zweite Ende ausgebildet ist, mit einem Signaleingang verbunden zu werden. Insbesondere können in dieser Ausführungsform sowohl das erste Ende als auch das zweite Ende außerhalb des Kerns angeordnet sein.

Das erste Ende ist dabei, wie zuvor beschrieben, außerhalb des Kerns angeordnet, um mit dem Signalerzeuger verbunden zu werden, während das andere Ende, insbesondere auf der gegenüberliegenden Seite entlang der Länge des Kerns angeordnet sein kann, um dort mit einem Signaleingang verbunden zu werden. Hierdurch können die Leitungsdurchgängigkeit und insbesondere Defekte der Hochfrequenzleitung gemessen und erfasst werden.

Gemäß einer Ausführungsform ist die Ummantelung aus einem metallischen Material ausgebildet. Die Ummantelung kann insbesondere als metallische Folie, weiter insbesondere als Alufolie ausgebildet sein. Insbesondere kann die Ummantelung nur teilweise und/oder abschnittweise aus einem metallischen Material ausgebildet sein, insbesondere an einer Position, an der eine Berührung erwartet und/oder gewünscht ist, beispielsweise in Richtung eines berührenden Gegenstands oder Fingers. Hierdurch können besonders gut die dielektrischen Einflüsse der Berührung mit den Wirkungen auf die Hochfrequenzleitung ausgenutzt werden.

Gemäß einer Ausführungsform ist die Ummantelung aus einem reversibel verformbaren Material ausgebildet. Alternativ oder zusätzlich ist der Kern aus einem reversibel verformbaren Material ausgebildet. Reversibel verformbar meint vorliegend, dass die Ummantelung durch eine Berührung zunächst verformbar ist, sich jedoch nach dem Ende der Berührung im Wesentlichen in ihre ursprüngliche Position bzw. Form zurückverformt.

Durch diese Ausführungsformen wird eine besonders wiederholbare Erfassung einer Berührung ermöglicht.

Gemäß einer Ausführungsform weist die Hochfrequenzleitung einen Wellenwiderstand von 50 Ohm auf. Insbesondere weist die Hochfrequenzleitung einen Wellenwiderstand von genau 50 Ohm auf. So werden Reflexionen bei - ebenfalls auf 50 Ohm normierten - Bauteilen, wie Stecker und Anschlusskabel vermieden bzw. verhindert.

Gemäß einer alternativen Ausführungsform weist die Hochfrequenzleitung einen Wellenwiderstand größer 50 Ohm auf. Insbesondere weist die Hochfrequenzleitung einen Wellenwiderstand von 100 Ohm oder mehr. Hierdurch wird eine besonders genaue Erfassung ermöglicht.

Gemäß einer Ausführungsform ist die Auswertungseinheit ausgebildet, einen Ort der Positionsänderung zu ermitteln. Insbesondere ist die Auswertungseinheit ausgebildet zu ermitteln, wo, insbesondere an welchem Ort, die Berührung stattgefunden hat. Die Eigenschaft, dass die Auswertungseinheit ausgebildet ist, zu erfassen wo die Berührung stattgefunden hat, kann entweder alternativ oder zusätzlich dazu, dass sie ausgebildet ist, zu erfassen ob eine Berührung aufgetreten ist, bestehen.

Alternativ oder zusätzlich ist die Auswertungseinheit ausgebildet, eine Kraft der Positionsänderung zu ermitteln. Insbesondere ist die Auswertungseinheit, alternativ oder zusätzlich dazu, dass sie ausgebildet ist, zu erfassen ob und/oder wo eine Berührung aufgetreten ist, ausgebildet zu ermitteln, wie stark die Berührung stattgefunden hat.

Insbesondere ist die Auswertungseinheit ausgebildet, mehrere Berührungen gleichzeitig zu erfassen, insbesondere ob und wie viele mehrere Berührungen stattgefunden haben und/oder wo mehrere Berührungen stattgefunden haben und/oder wie stark die mehreren Berührungen stattgefunden haben.

Weiter insbesondere ist die Auswertungseinheit ausgebildet, zweistufig zu arbeiten. Zweistufig meint vorliegen, dass die Auswertungseinheit zunächst erfasst ob eine oder mehrere Berührungen stattgefunden haben und erst danach erfasst wo und/oder wie stark eine oder mehrere Berührungen stattgefunden haben.

Durch diese Ausführungsformen wird eine besonders vielseitige Vorrichtung ermöglicht.

Insbesondere ist die Auswertungseinheit ausgebildet, die Positionsänderung mithilfe von künstlicher Intelligenz zu ermitteln. Insbesondere ist die Auswertungseinheit ausgebildet, mithilfe von künstlicher Intelligenz zu ermitteln, ob eine Berührung stattgefunden hat. Alternativ oder zusätzlich ist die Auswertungseinheit ausgebildet, mithilfe von künstlicher Intelligenz zu ermitteln wo eine Berührung stattgefunden hat. Weiter alternativ oder zusätzlich ist die Auswertungseinheit ausgebildet, mithilfe von künstlicher Intelligenz zu ermitteln wie stark eine Berührung stattgefunden hat.

Weiter insbesondere ist die Auswertungseinheit ausgebildet, Beschädigungen und/oder Materialermüdungen, insbesondere an reversibel verformbaren Elementen, zu erkennen und zu kompensieren. Dies kann insbesondere auch mithilfe von künstlicher Intelligenz erfolgen. Alternativ oder zusätzlich kann die Kompensation auch durch klassische Filterung, beispielsweise durch Scharmittelung erfolgen. Künstliche Intelligenz meint vorliegend insbesondere eine Verwendung von maschinellem Lernen und/oder die Anwendung eines künstlichen neuronalen Netzwerks. Insbesondere verwendet die künstliche Intelligenz einen hierfür bereitgestellten FPGA und nutzt beispielsweise ein 2f-Verfahren und Time-Hopping. So wird eine besonders störsichere Ermittlung ermöglicht.

Durch diese Ausführungsform wird eine besonders genaue Ermittlung der Berührung ermöglicht. Insbesondere ist die künstliche Intelligenz, nach erfolgtem Training, ausgebildet, auf verschiedene Vorrichtungen und insbesondere auf verschieden gestaltete Berührungselemente übertragen zu werden und dort, ohne weiteres Training oder eine Benutzereingabe, sicher und zuverlässig Berührungen zu erkennen.

Gemäß einer Ausführungsform ist der Signalerzeuger ausgebildet, das Hochfrequenzsignal unter Verwendung von Zeitbereichsreflektometrie zu erzeugen und die Reflexion des Hochfrequenzsignals unter Verwendung von Zeitbereichsreflektometrie zu erfassen. Zeitbereichsreflektometrie, welche auch mit TDR, engl. time domain reflectometry, bezeichnet werden kann, ist ein Verfahren zur Ermittlung und Analyse von Lauflängen und Reflexionscharakteristika von elektromagnetischen Signalen auf Leitungen. Dieses Verfahren kann auch als Kabelradar bezeichnet werden.

Durch diese Ausführungsform wird eine besonders zuverlässige und genaue Erkennung einer Berührung ermöglicht.

Die eingangs genannte Aufgabe wird auch gelöst durch einen Roboter, umfassend eine zuvor beschriebene Ausführungsform der Vorrichtung zur Erkennung einer Berührung.

Somit wird ein besonders sicherer Roboter ermöglicht, der Berührungen erkennen kann.

Insbesondere kann der Signalerzeuger und die Auswertungseinheit ortsfest am oder in der Nähe des Roboters angeordnet sein, während das Berührungselement mit einem beweglichen Teil des Roboters, beispielsweise einem Arm, verbunden ist bzw. daran angeordnet ist. So kann die bewegte Masse am Roboter gering gehalten werden.

Gemäß einer Ausführungsform umfasst der Roboter weiter eine Steuereinheit, die ausgebildet ist, eine Bewegung des Roboters basierend auf der ermittelten Positionsänderung zu steuern. Insbesondere ist die Steuereinheit ausgebildet, bei Erkennung einer Berührung eine Bewegung, insbesondere eine Bewegungsrichtung, zu ändern und/oder zu stoppen.

Durch diese Ausführungsform wird ein besonders sicherer Roboter ermöglicht, der insbesondere gut im Umfeld zusammen mit Menschen eingesetzt werden kann.

Bezüglich der weiteren Ausgestaltungen und Vorteile des Roboters wird auf die oben genannten Ausgestaltungen und Vorteile der Vorrichtung zur Erkennung einer Berührung verwiesen.

Die eingangs genannte Aufgabe wird auch gelöst durch ein Verfahren zur Erkennung einer Berührung. Das Verfahren umfasst dabei die Schritte Beaufschlagen einer Hochfrequenzleitung mit einem Hochfrequenzsignal, wobei die Hochfrequenzleitung in einem Kern aus einem dielektrischen Material angeordnet ist und eine Ummantelung, die ein Bezugspotential für die Hochfrequenzleitung ausbildet, um den Kern angeordnet ist, Erfassen einer Reflexion des Hochfrequenzsignals an der Hochfrequenzleitung, Auswerten einer durch eine Positionsänderung der Ummantelung relativ zu der Hochfrequenzleitung geänderte Reflexion des Hochfrequenzsignals und Ermitteln der Positionsänderung basierend auf der geänderten Reflexion.

Dabei kann das Verfahren insbesondere von einer zuvor beschriebenen Vorrichtung durchgeführt werden. Insbesondere wird der Schritt des Beaufschlagens und Erfassens mithilfe des zuvor beschriebenen Signalerzeugers und/oder der Schritt des Auswertens und Ermittelns mithilfe der zuvor beschriebenen Auswertungseinheit durchgeführt.

Insbesondere kann in einem weiteren, zuerst erfolgten Schritt eine Ausführungsform einer zuvor beschriebenen Vorrichtung bereitgestellt werden.

Bezüglich der Ausgestaltungen und Vorteile des Verfahrens zur Erkennung einer Berührung wird auf die oben genannten Ausgestaltungen und Vorteile der Vorrichtung zur Erkennung einer Berührung verwiesen.

Erfindungsgemäß wird auch ein Berührungselement angegeben, umfassend einen Kern aus einem dielektrischen Material, eine in dem Kern angeordnete Hochfrequenzleitung und eine um den Kern angeordnete Ummantelung, die ein Bezugspotential für die Hochfrequenzleitung ausbildet. Die Hochfrequenzleitung ist dabei insbesondere ausgebildet, mit einem Signalerzeuger verbunden zu werden, der ausgebildet ist, ein Hochfrequenzsignal zu erzeugen und die Hochfrequenzleitung damit zu beaufschlagen und eine Reflexion des Hochfrequenzsignals an der Hochfrequenzleitung zu erfassen.

Bezüglich der Ausgestaltungen und Vorteile des Berührungselements wird auf die oben genannten Ausgestaltungen und Vorteile der Vorrichtung zur Erkennung einer Berührung verwiesen.

Es versteht sich, dass sämtliche hierin genannten Merkmale und Ausführungsformen miteinander kombinierbar sind, sofern nicht explizit etwas gegenteiliges angegeben ist.

Ausführungsformen des Berührungselements, der Vorrichtung und des Verfahren zur Erkennung einer Berührung werden nun im Zusammenhang mit den folgenden Figuren erläutert. Es zeigen:
- Fig. 1: eine schematische Ansicht einer Ausführungsform einer Vorrichtung zur Erkennung einer Berührung;
- Fig. 2: eine schematische Schnittansicht in Draufsicht einer Ausführungsform eines Berührungselements aus Fig. 1;
- Fig. 3: eine schematische Schnittansicht in Draufsicht einer weiteren Ausführungsform eines Berührungselements aus Fig. 1;
- Fig. 4: eine schematische Schnittansicht in Draufsicht einer weiteren Ausführungsform eines Berührungselements aus Fig. 1;
- Fig. 5: eine schematische Schnittansicht in Seitenansicht entlang A-A aus Fig. 2;
- Fig. 6: eine Berührung des Berührungselements aus Fig. 5; und
- Fig. 7: ein Ablaufdiagramm einer Ausführungsform eines Verfahrens zur Erkennung einer Berührung.

Dabei bezeichnen gleiche Bezugszeichen gleiche oder ähnliche Merkmale.

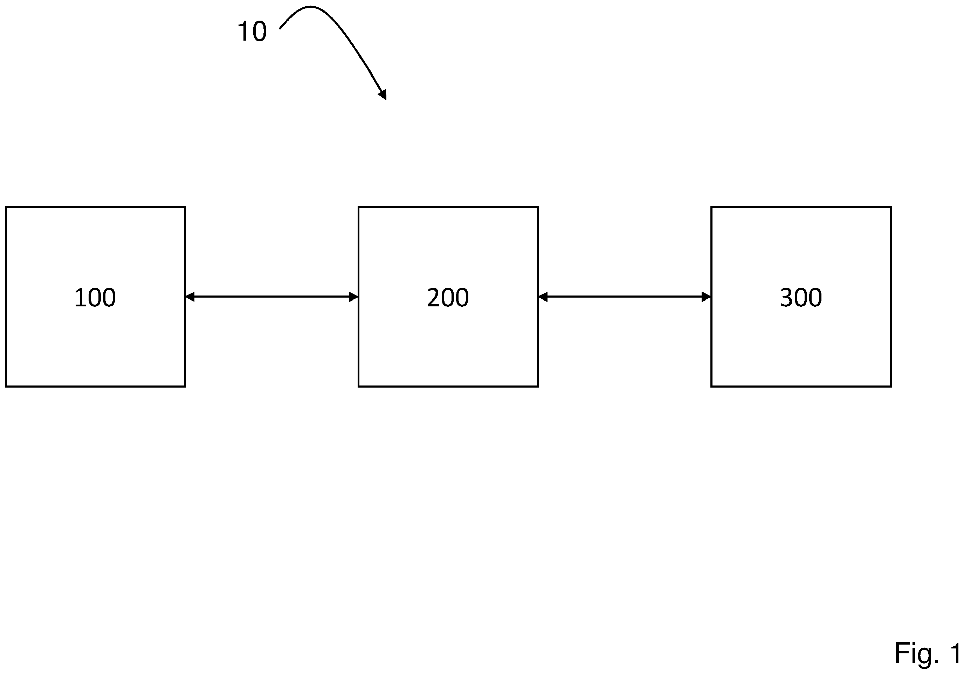

Fig. 1 zeigt eine schematische Ansicht einer Ausführungsform einer Vorrichtung 10 zur Erkennung einer Berührung.

Die Vorrichtung 10 umfasst dabei ein Berührungselement 100, einen Signalerzeuger 200, und eine Auswertungseinheit 300.

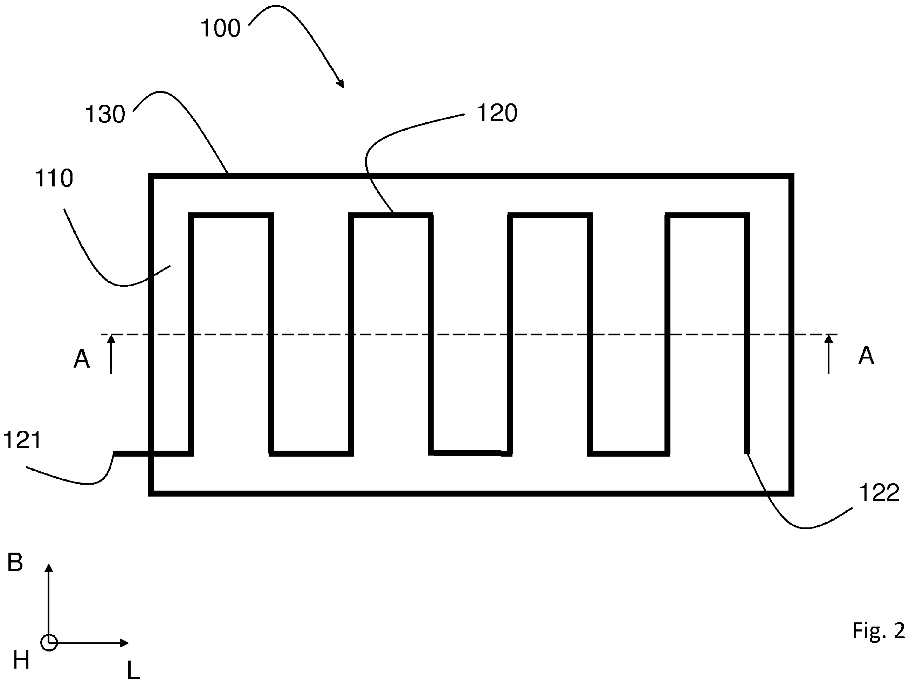

Das Berührungselement 100, welches im Detail in den Figuren 2 bis 6 gezeigt ist, umfasst dabei einen Kern, eine in dem Kern angeordnete Hochfrequenzleitung und eine um den Kern angeordnete Ummantelung, die alle drei aus Gründen der Übersichtlichkeit in dieser Figur nicht abgebildet sind.

Der Signalerzeuger 200 ist mit der Hochfrequenzleitung des Berührungselements 100 verbunden und ausgebildet, ein Hochfrequenzsignal zu erzeugen und die Hochfrequenzleitung damit zu beaufschlagen sowie eine Reflexion des Hochfrequenzsignals an der Hochfrequenzleitung unter Verwendung von Zeitbereichsreflektometrie zu erfassen.

Die Auswertungseinheit 300 ist mit dem Signalerzeuger 200 verbunden und ausgebildet, eine durch eine Positionsänderung der Ummantelung des Berührungselements 100 relativ zu der Hochfrequenzleitung des Berührungselements 100 geänderte Reflexion des Hochfrequenzsignals auszuwerten und die Positionsänderung mithilfe von künstlicher Intelligenz zu ermitteln. Die Auswertungseinheit 300 ist auch ausgebildet, mithilfe von künstlicher Intelligenz einen Ort und eine Kraft der Positionsänderung zu ermitteln.

Fig. 2 zeigt eine schematische Schnittansicht in Draufsicht einer Ausführungsform eines Berührungselements 100 wie in Fig. 1 gezeigt.

Das Berührungselement 100 umfasst dabei einen Kern 110 aus einem dielektrischen Material, eine in dem Kern 110 angeordnete Hochfrequenzleitung 120 und eine um den Kern 110 angeordnete Ummantelung 130, welche ein Bezugspotential für die Hochfrequenzleitung 120 ausbildet. Dazu ist die Ummantelung 130 aus einem metallischen Material ausgebildet und mit der Hochfrequenzleitung 120 elektrisch leitend verbunden. Die Ummantelung 130 erstreckt sich dabei über die komplette Breite B, Länge L und Höhe H des Kerns 110.

Die Hochfrequenzleitung 120 weist dabei ein erste Ende 121 auf, das außerhalb des Kerns angeordnet und mit dem Signalerzeuger verbunden ist und ein zweites Ende 122, das innerhalb des Kerns 110 angeordnet ist. Das erste Ende 121 ist dabei ausgebildet, mit dem Signalerzeuger wie in Fig. 1 gezeigt, verbunden zu werden. Dazu kann das erste Ende 121 insbesondere einen Koaxialanschluss aufweisen bzw. damit kompatibel sein.

Das Berührungselement 100 erstreckt sich dabei entlang einer Länge L und einer Breite B und weist eine im Wesentlichen rechteckige Form auf. Das Berührungselement 100 erstreckt sich auch in eine Höhe H, die in die Zeichenebene hinein- bzw. daraus herausragt.

Die Hochfrequenzleitung 120 ist dabei schlangenförmig innerhalb des Kerns 110 angeordnet. Wie in dieser Fig. 2 gezeigt breitet sich die Hochfrequenzleitung 120 entlang der Länge L schlangenförmig aus. Dabei erstreckt sich zunächst, von dem ersten Ende 121 kommend, ein erste Abschnitt entlang der Länge L, um dann in einen zweiten Abschnitt überzugehen, der sich im Wesentlichen senkrecht zur Länge L, das bedeutet entlang der Breite B erstreckt. Daran schließt sich ein weiterer, dritter Abschnitt an, der sich wieder entlang der Länge L erstreckt und dann in einen vierten Abschnitt überzugehen, der sich entlang der negativen Breite B erstreckt. Ab dann wiederholt sich dieses Muster, bis zum zweiten Ende 122 der Hochfrequenzleitung 120, das im Kern 110 angeordnet ist und darin terminiert.

Es versteht sich, dass die Hochfrequenzleitung 120 in dem rechteckigen Schlangenmuster nicht lediglich vier Mal, wie beispielhaft in Fig. 2 gezeigt, sondern beliebig oft entlang der Länge L des Kerns 110 wiederholt sein kann und sich somit über eine beliebige, vordefinierte Länge L des Kerns 110 erstrecken kann. Insbesondere kann die Hochfrequenzleitung 120 auch an einem anderen, beliebigen Punkt entlang der Schlangenform terminieren.

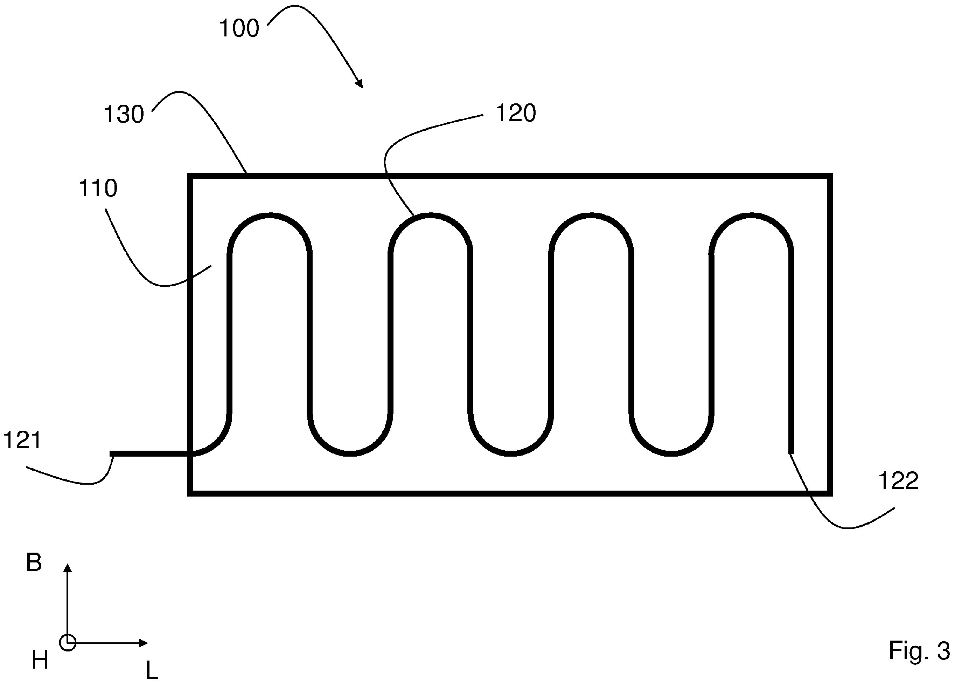

Fig. 3 zeigt eine schematische Schnittansicht in Draufsicht einer weiteren Ausführungsform eines Berührungselements 100.

Dabei ist abweichend von dem in Fig. 2 gezeigten Ausführungsbeispiel die Hochfrequenzleitung 120 zwar weiterhin schlangenförmig ausgebildet, jedoch nicht mit im Wesentlichen rechtwinkligen Richtungswechseln in der Ausbreitungsrichtung entlang der Länge L und Breite B, sondern mit im Wesentlichen abgerundeten, das bedeutet gekrümmten bzw. abgerundeten Richtungswechseln.

Dabei verläuft die Hochfrequenzleitung 120 zunächst ebenfalls entlang der Länge L, um dann in einem Viertelkreis in eine Erstreckung entlang der Breite B überzugehen. Hieran schließt sich ein Halbkreis an, um dann in eine Erstreckung entlang der negativen Breite B überzugehen. Ab dann wiederholt sich dieses Muster, bis zum zweiten Ende 122 der Hochfrequenzleitung 120, das im Kern 110 angeordnet ist und darin terminiert.

Es versteht sich, dass die Hochfrequenzleitung 120 in dem abgerundeten Schlangenmuster nicht lediglich vier Mal, wie beispielhaft in Fig. 3 gezeigt, sondern beliebig oft entlang der Länge L des Kerns 110 wiederholt sein kann und sich somit über eine beliebige, vordefinierte Länge L des Kerns 110 erstrecken kann. Insbesondere kann die Hochfrequenzleitung 120 auch an einem anderen, beliebigen Punkt entlang der Schlangenform terminieren.

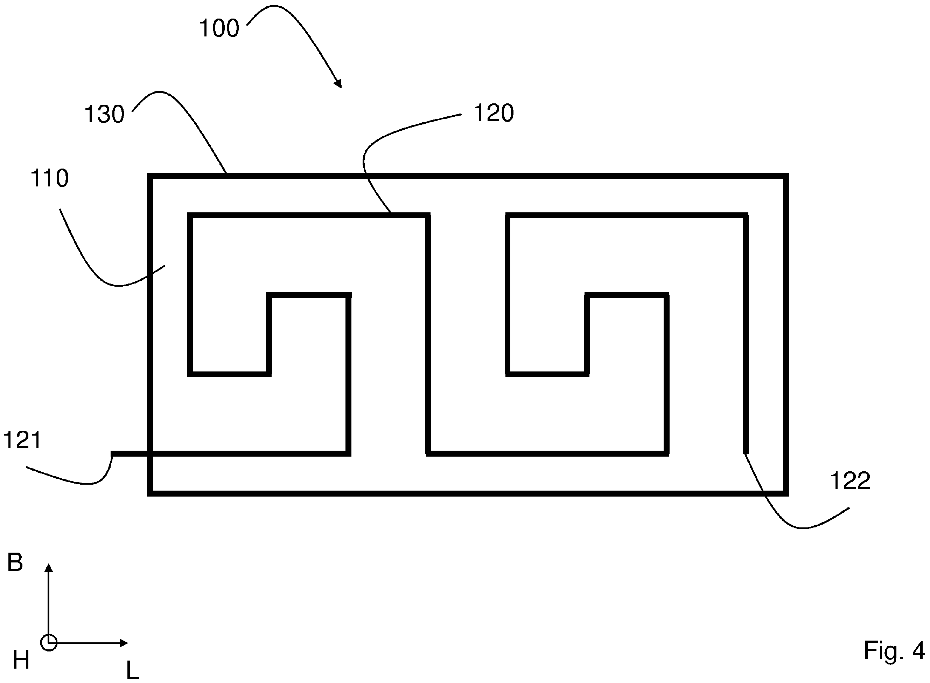

Fig. 4 zeigt eine schematische Schnittansicht in Draufsicht einer weiteren Ausführungsform eines Berührungselements 100.

Dabei ist abweichend von dem in Fig. 2 gezeigten Ausführungsbeispiel die Hochfrequenzleitung 120 zwar weiterhin schlangenförmig ausgebildet, jedoch nicht mit alternierenden Richtungswechseln entlang der Breite B und der Länge L, sondern mit mäanderförmigen Richtungswechseln.

Dazu verläuft die Hochfrequenzleitung 120 zunächst entlang der Länge L, um dann rechtwinklig abzuknicken und entlang der Breite B zu verlaufen. Abweichend zu dem in Fig. 2 gezeigten Ausführungsbeispiel verläuft dann die Hochfrequenzleitung 120 entgegengesetzt der Länge L um dann in einen Abschnitt entgegengesetzt der Breite B überzugehen. Dann geht die Hochfrequenzleitung in einen weiteren Abschnitt entgegengesetzt der Länge L über, um sodann in einen folgenden Abschnitt, erneut entlang der Breite B überzugehen. Dann geht die Hochfrequenzleitung 120 in einen weiteren Abschnitt entlang der Länge L über, um sodann in einen folgenden Abschnitt entgegengesetzt der Breite B überzugehen. Ab dann wiederholt sich dieses Muster, bis zum zweiten Ende 122 der Hochfrequenzleitung 120, das im Kern 110 angeordnet ist und darin terminiert.

Es versteht sich, dass die Hochfrequenzleitung 120 in dem mäanderförmigen Schlangenmuster nicht lediglich zwei Mal, wie beispielhaft in Fig. 4 gezeigt, sondern beliebig oft entlang der Länge L des Kerns 110 wiederholt sein kann und sich somit über eine beliebige, vordefinierte Länge L des Kerns 110 erstrecken kann. Insbesondere kann die Hochfrequenzleitung 120 auch an einem anderen, beliebigen Punkt entlang der Schlangenform terminieren.

Es versteht sich weiter, dass auch Mischformen möglich sind, beispielsweise eine Mäanderform mit abgerundeten und/oder halbkreisförmigen Übergängen. In einem weiteren, nicht gezeigten Ausführungsbeispiel verläuft die Hochfrequenzleitung gemäß einer Hilbert-Kurve, insbesondere einer Hilbert-Kurve der 2. Iteration, die dem Mäandermuster ähnlich ist.

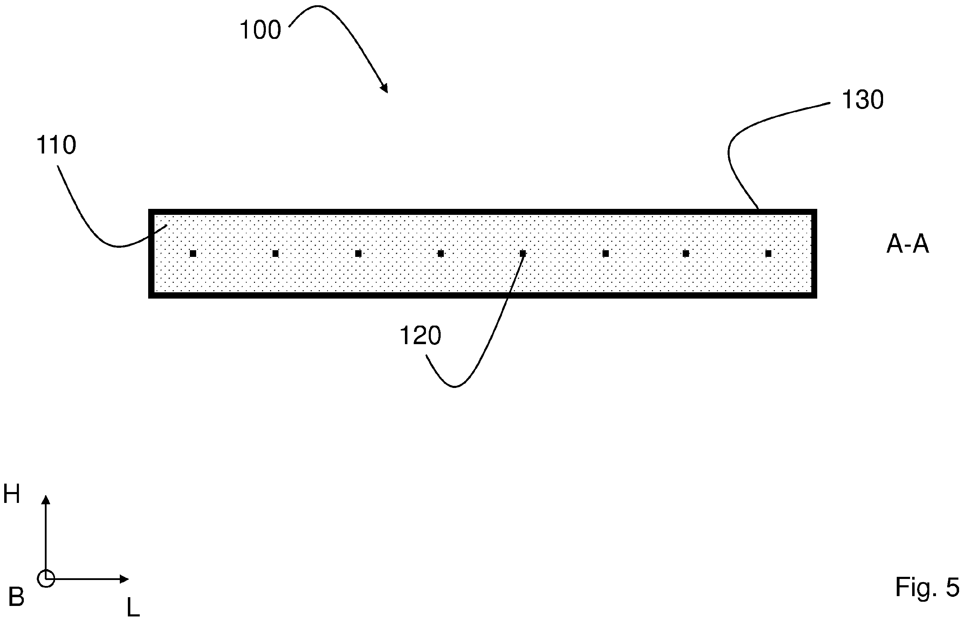

Fig. 5 zeigt eine schematische Schnittansicht in Seitenansicht entlang der Linie A-A aus Fig. 2 des Berührungselements 100, also entlang der Länge L.

In Fig. 5 ist insbesondere die Ummantelung 130 gezeigt, die um den Kern 110 angeordnet ist. Die Ummantelung 130 bildet dabei ein Bezugspotential für die Hochfrequenzleitung 120 aus, die in dem Kern 110 angeordnet ist. Die Ummantelung 130 ist aus einem metallischen Material ausgebildet und erstreckt sich dabei über die komplette Breite B, Länge L und Höhe H des Kerns 110.

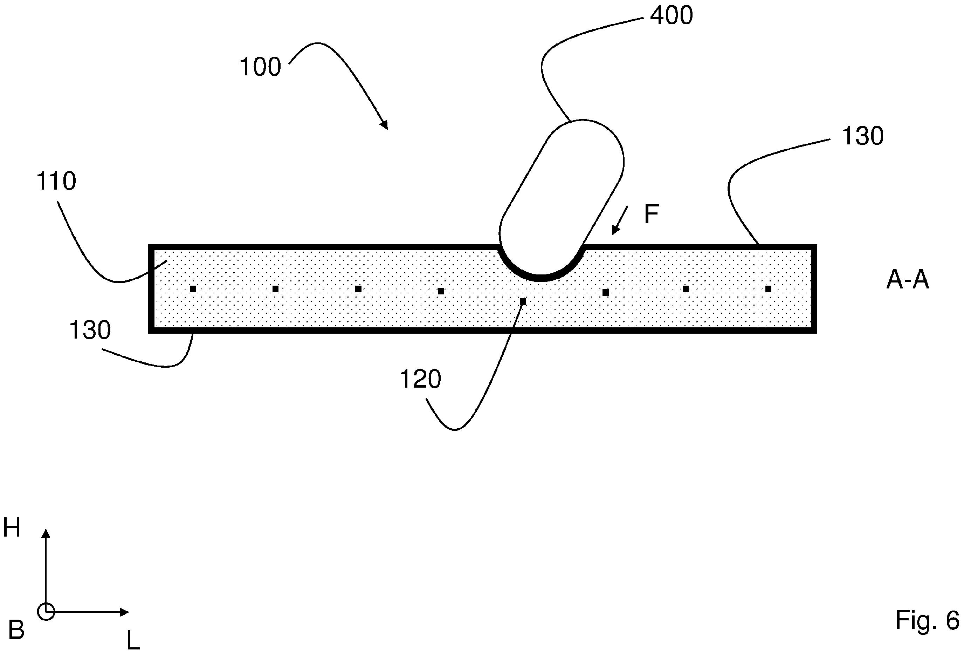

In Fig. 6 ist eine Berührung des Berührungselements 100 aus Fig. 5 durch einen Gegenstand 400 gezeigt.

Bei dem Gegenstand 400 kann es sich entweder um ein menschliches Körperteil, wie beispielsweise eine Gliedmaße handeln, oder auch um einen künstlichen Gegenstand, wie beispielsweise ein Werkzeug.

Wie in Fig. 6 zu sehen, drückt der Gegenstand 400 beispielhaft gegen eine obere Oberfläche des Berührungselements 100 und verändert so die Position der Ummantelung 130 relativ zu der Hochfrequenzleitung 120. Insbesondere wird durch die Berührung des Berührungselements 100 durch den Gegenstand 400 sowohl der Abstand zwischen der Ummantelung 130 zu der Hochfrequenzleitung 120 verändert als auch die Position der Hochfrequenzleitung 120 innerhalb des Kerns 110.

Durch diese Positionsänderung der Ummantelung 130 relativ zu der Hochfrequenzleitung 120 wird eine Reflexion des Hochfrequenzsignals verändert, wobei diese Änderung von der in Fig. 1 gezeigten Auswertungseinheit ausgewertet und somit eine Positionsänderung als solche, einen Ort und auch eine Kraft der Positionsänderung ermittelt werden kann.

Sowohl der Kern 110 als auch die Ummantelung 130 sind dabei aus einem reversibel verformbaren Material ausgebildet und nehmen nach der durch den Gegenstand 400 induzierte Positionsänderung die ursprüngliche Position wieder ein, sodass das Berührungselement 100 nach dem Ende der Berührung durch den Gegenstand 400 wieder in eine Ausgangsposition, wie in Fig. 5 gezeigt, zurückkehrt.

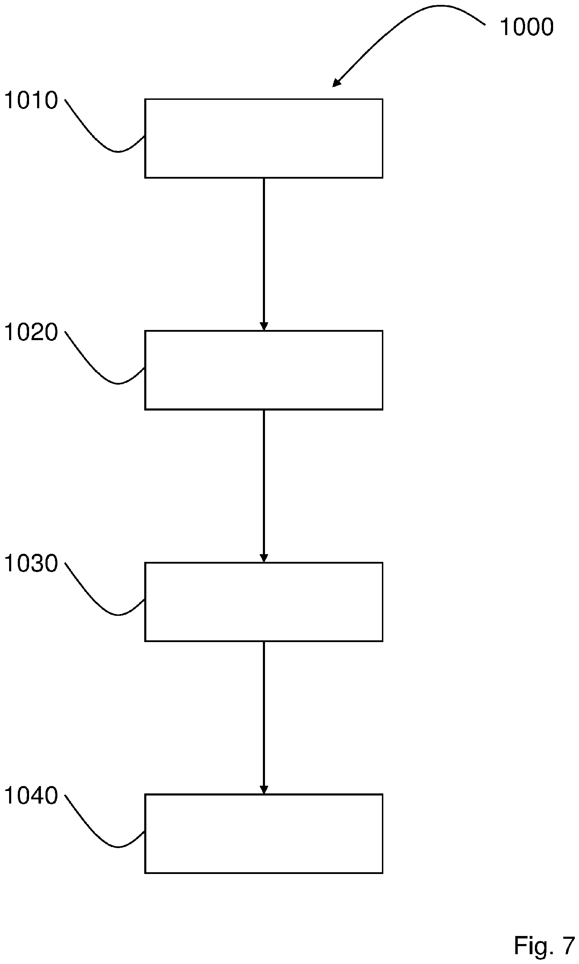

Fig. 7 ein Ablaufdiagramm einer Ausführungsform eines Verfahrens 1000 zur Erkennung einer Berührung.

Das Verfahren beginnt in einem ersten Schritt 1010, in dem eine Hochfrequenzleitung mit einem Hochfrequenzsignal beaufschlagt wird. Die Hochfrequenzleitung ist dabei in einem Kern aus einem dielektrischen Material angeordnet und eine Ummantelung, die ein Bezugspotential für die Hochfrequenzleitung ausbildet, ist um den Kern herum angeordnet, wie in den vorherigen Fig. 2 bis 6 gezeigt. Das Beaufschlagen erfolgt insbesondere durch den in Fig. 1 gezeigten Signalerzeuger.

In einem weiteren Schritt 1020 wird eine Reflexion des Hochfrequenzsignals an der Hochfrequenzleitung ermittelt. Auch dies erfolgt insbesondere durch den in Fig. 1 gezeigten Signalerzeuger.

In einem darauffolgenden Schritt 1030 wird eine durch eine Positionsänderung der Ummantelung relativ zu der Hochfrequenzleitung geänderte Reflexion des Hochfrequenzsignals ermittelt. Dies erfolgt insbesondere durch eine Auswertungseinheit 300, wie in Fig. 1 gezeigt.

In einem weiteren Schritt 1040 wird die Positionsänderung basierend auf der geänderten Reflexion ermittelt. Auch dies erfolgt insbesondere durch eine Auswertungseinheit 300, wie in Fig. 1 gezeigt.

### Bezugszeichenliste

- 10: Vorrichtung
- 100: Berührungselement
- 110: Kern
- 120: Hochfrequenzleitung
- 121: erstes Ende
- 122: zweits Ende
- 130: Ummantelung
- 200: Signalerzeuger
- 300: Auswertungseinheit
- 400: Gegenstand
- 1000: Verfahren
- 1010: Verfahrensschritt
- 1020: Verfahrensschritt
- 1030: Verfahrensschritt
- 1040: Verfahrensschritt
- A-A: Schnittebene
- B: Breite
- F: Kraft
- H: Höhe
- L: Länge

## Patentansprüche

1. Vorrichtung (10) zur Erkennung einer Berührung, umfassend:
- ein Berührungselement (100), umfassend:
- einen Kern (110) aus einem dielektrischen Material;
- eine in dem Kern (110) angeordnete Hochfrequenzleitung (120); und
- eine um den Kern (110) angeordnete Ummantelung (130), die ein Bezugspotential für die Hochfrequenzleitung (120) ausbildet;
- einen mit der Hochfrequenzleitung (120) des Berührungselements (100) verbundenen Signalerzeuger (200), der ausgebildet ist, ein Hochfrequenzsignal zu erzeugen und die Hochfrequenzleitung damit zu beaufschlagen und eine Reflexion des Hochfrequenzsignals an der Hochfrequenzleitung zu erfassen; und
- eine mit dem Signalerzeuger (200) verbundene Auswertungseinheit (300), die ausgebildet ist, eine durch eine Positionsänderung der Ummantelung (130) relativ zu der Hochfrequenzleitung (120) geänderte Reflexion des Hochfrequenzsignals auszuwerten und die Positionsänderung zu ermitteln.

2. Vorrichtung (10) nach Anspruch 1,
wobei die Hochfrequenzleitung (120) schlangenförmig innerhalb des Kerns (110) angeordnet ist.

3. Vorrichtung (10) nach einem der vorhergehenden Ansprüche 1 oder 2, wobei ein erstes Ende (121) der Hochfrequenzleitung (120) mit dem Signalerzeuger verbunden ist und ein zweites Ende (122) der Hochfrequenzleitung (120) innerhalb des Kerns (110) angeordnet ist.

4. Vorrichtung (10) nach einem der vorhergehenden Ansprüche, wobei die Ummantelung (130) aus einem metallischen Material ausgebildet ist.

5. Vorrichtung (10) nach einem der vorhergehenden Ansprüche, wobei die Ummantelung (130) aus einem reversibel verformbaren Material ausgebildet ist.

6. Vorrichtung (10) nach einem der vorhergehenden Ansprüche, wobei der Kern (110) aus einem reversibel verformbaren Material ausgebildet ist.

7. Vorrichtung (10) nach einem der vorhergehenden Ansprüche, wobei die Hochfrequenzleitung (120) einen Wellenwiderstand von 50 Ohm aufweist.

8. Vorrichtung (10) nach einem der vorhergehenden Ansprüche 1 bis 6, wobei die Hochfrequenzleitung (120) einen Wellenwiderstand größer 50 Ohm aufweist.

9. Vorrichtung (10) nach einem der vorhergehenden Ansprüche, wobei die Auswertungseinheit (300) ausgebildet ist, einen Ort der Positionsänderung zu ermitteln.

10. Vorrichtung (10) nach einem der vorhergehenden Ansprüche, wobei die Auswertungseinheit (300) ausgebildet ist, eine Kraft der Positionsänderung zu ermitteln.

11. Vorrichtung (10) nach einem der vorhergehenden Ansprüche, wobei die Auswertungseinheit (300) ausgebildet ist, die Positionsänderung mithilfe von künstlicher Intelligenz zu ermitteln.

12. Vorrichtung (10) nach einem der vorhergehenden Ansprüche,
wobei der Signalerzeuger (200) ausgebildet ist das Hochfrequenzsignal unter Verwendung von Zeitbereichsreflektometrie zu erfassen.

13. Roboter, umfassend eine Vorrichtung (10) nach einem der vorhergehenden Ansprüche 1 bis 12.

14. Roboter nach Anspruch 13, weiter umfassend eine Steuereinheit, die ausgebildet ist, eine Bewegung des Roboters basierend auf der ermittelten Positionsänderung zu steuern.

15. Verfahren (1000) zur Erkennung einer Berührung, umfassend:
- Beaufschlagen (1010) einer Hochfrequenzleitung (120) mit einem Hochfrequenzsignal, wobei die Hochfrequenzleitung (120) in einem Kern (110) aus einem dielektrischen Material angeordnet ist und eine Ummantelung (130), die ein Bezugspotential für die Hochfrequenzleitung (120) ausbildet, um den Kern (110) angeordnet ist;
- Erfassen (1020) einer Reflexion des Hochfrequenzsignals an der Hochfrequenzleitung (120);
- Auswerten (1030) einer durch eine Positionsänderung der Ummantelung (130) relativ zu der Hochfrequenzleitung (120) geänderte Reflexion des Hochfrequenzsignals; und
- Ermitteln (1040) der Positionsänderung basierend auf der geänderten Reflexion.
